# EUROPEAN PATENT APPLICATION

(11) **EP 0 638 656 A1**
(43) Date of publication of application: **15.02.1995**
(21) Application number: 93903300.7
(22) Date of filing: 03.02.1993
(51) Int. Cl.: C22C 13/00, C22C 11/06, C22C 5/04, C23C 30/00, B23K 1/20, H05K 3/42, B23K 35/26

(54) **ALLOY TO BE PLATED, ITS PLATING METHOD AND PLATING SOLUTION**

(71) Applicant: WORLD METAL CO., LTD., Osaka-shi, Osaka 536 (JP)
(72) Inventor: UEDA, Shigeaki, Shijonawate-shi, Osaka 575 (JP); HAYASHIDA, Hidenori, Takatsuki-shi, Osaka 569 (JP)
(74) Representative: Müller-Boré & Partner Patentanwälte
(86) International application number: JP9300129
(87) International publication number: WO9418350

(57) **Abstract**

When an electronic component and a wiring board are connected to each other by soldering, the present invention uses, as an alloy to be plated, an alloy containing 0.01 to 90 wt% of palladium in lead, tin or their alloy as a thin film to be formed on a to-be-plated portion of the electronic component or the wiring board so as to effectively carry out the connection. Particularly preferred is an alloy containing 0.1 to 70 wt% of lead, 0.1 to 90 wt% of tin and 0.01 to 90 wt% of palladium. Furthermore, when this alloy further contains 0.1 to 20 wt% of phosphorus or 0.01 to 10 wt% of boron, the drop of solderability of the alloy due to heat can be much more reduced. When 0.1 to 20 wt% of indium is contained, the melting point of the alloy can be lowered and when 0.1 to 20 wt% of silver is contained, leaching can be reduced. This alloy to be plated is preferably formed on the to-be-plated portion by electrolytic or electroless plating by the use of a plating solution for the alloy to be plated which contains 0.001 to 2 mols/l of a palladium compound, 0.001 to 3 mols/l of a tin compound and or 0.001 to 2 mols/l of a lead compound. In the case of electroless plating, it is preferred to use a plating solution additionally containing 0.01 to 1 mol/l of a reducing agent.

## Description

### TECHNICAL FIELD

This invention relates to a solderable alloy mainly composed of lead or tin or both of them. More particularly, it relates to a solderable alloy that has a superior solderability, may hardly cause deterioration of its solderability on account of heat or humidity, requires no flux treatment when soldered, and therefore makes it unnecessary to use fluorine type solvents such as chlorofluorocarbons or chlorine type solvents such as trichloroethylene commonly used to remove the flux by cleaning after soldering has been completed.

### BACKGROUND ART

In the connection of electronic parts through wiring, soldering has been hitherto widely applied. For example, in printed circuit boards, a solder layer is directly formed on the portions to be soldered on the board, e.g., on the lands of copper through-holes or the inside surfaces of the through-holes, by the solder leveler process or dip soldering, and thereafter leads of electronic parts such as resistors are inserted into the through-holes, followed by dipping in a solder bath to carry out soldering.

Incidentally, in recent years, with an improvement in wiring density on printed circuit boards and a tendency toward multilayer structure of the boards themselves, the through-holes have become smaller in diameter and higher in their aspect ratios. In the case of such printed circuit boards with high-density wiring, formation of solder layers on the inside surfaces of through-holes by the conventional solder leveler process or dip soldering has been involved in the problem that the through-holes are clogged with solder to make it impossible to insert the leads of electronic parts into the holes, or solder bridges are formed between the lands of through-holes to cause short circuit.

The surfaces of solder layers formed by the conventional solder leveler process or the like are not smooth but protuberant. Hence, when electronic parts are connected by what is called surface mounting, there is another problem that the electronic parts tend to be misregistered and it is difficult to automate the surface mounting.

Accordingly, in printed circuit boards with high-density wiring, a thin film of a solderable metal such as solder, tin, nickel or gold is previously formed on the portions to be soldered, e.g., on the inside surfaces of through-holes, by electrolytic plating or electroless plating. Thereafter, like the conventional cases, the leads of electronic parts are inserted into the through-holes, and the insides of the through-holes are filled with solder by dip soldering or the like to make connections between electronic parts and wiring, or electronic parts having leads coated with solder are placed on the solderable metal thin film, which are then heated in a solder reflowing oven to make connections between electronic parts and wiring.

Of the conventional solderable metals, gold has an excellent solderability and also has the advantage that its solderability may hardly deteriorate because of influence by heat or humidity. It, however, has been involved in the problem of high production cost.

Solderable metals other than the gold can not be said to have a satisfactory solderability, and also have had the problem that the solderability tends to deteriorate because of influence by heat or humidity.

The problem that the solderability deteriorates because of influence by heat or humidity is a very great problem in the present circumstances in which soldering is usually carried out not immediately after the formation of the thin film of a solderable alloy but often several months after its formation.

Moreover, when the thin film of a solderable metal is formed by electroless plating, there have been the problem that solder plating solutions or tin plating solutions have a low solution stability, the problem that titanium chloride, thiourea or the like must be used as a reducing agent and hence the titanium or sulfur that adversely affects the solderability can be included into the solderable metal thin film, and also the problem that it is difficult to control the thickness of the solderable metal thin film, in particular, it is very difficult to provide a thick film.

Soldering carried out on the solderable metal thin film formed by the conventional electrolytic plating or electroless plating has been also involved in the problem that it requires complicated operations such that soldering is carried out after a flux treatment has been applied in order to remove stains such as oxide coatings of the solderable metal thin film and thereafter the remaining flux is removed by cleaning. Moreover, the removing of flux by cleaning has had the problem that the fluorine type solvents such as chlorofluorocarbons or chlorine type solvents such as trichloroethylene that may adversely affect human bodies or global environment must be used.

The present invention intends to solve the above problems involved in the prior art. An object thereof is to make it possible to provide at a low cost a solderable alloy that has a superior solderability, may hardly cause deterioration of its solderability on account of heat or humidity, requires no flux treatment when soldered, and therefore makes it unnecessary to use fluorine type solvents or chlorine type solvents commonly used to remove the flux by cleaning that remains after soldering has been completed.

### DISCLOSURE OF THE INVENTION

The present inventors have discovered that the above object can be achieved by incorporating palladium into a solderable alloy mainly composed of lead or tin. The present invention was thus accomplished.

The present invention provides a solderable alloy comprising lead and/or tin, wherein palladium is contained in an amount of from 0.01 to 90% by weight.

### BEST MODE FOR WORKING THE INVENTION

The present invention will be described below in detail.

The solderable alloy of the present invention is mainly composed of lead or tin or an alloy of these, having an excellent solderability, and is characterized by further containing palladium. Incorporation of the palladium makes the solderability substantially not deteriorate on account of heat or humidity, and also makes it unnecessary to apply any flux treatment when soldering is carried out. Hence, it becomes unnecessary to remove the flux by cleaning after soldering has been completed, using fluorine type solvents or chlorine type solvents.

The palladium used in the solderable alloy of the present invention is in a content of from 0.01 to 90% by weight, preferably from 0.1 to 50% by weight, and more preferably from 1 to 30% by weight. Its use in a content less than 0.01% by weight tends to cause deterioration of the solderability because of influence by heat or humidity. Its use in a content more than 90% by weight may disadvantageously result in an excessive increase in formation cost.

The content of lead and tin in the solderable alloy of the present invention can be appropriately determined. Thus, any one of lead and tin need not be contained. In view of adhesion to solder, it is preferred that lead is contained in an amount of from 0.1 to 70% by weight, and preferably from 1 to 60% by weight, and tin in an amount of from 0.1 to 90% by weight, and preferably from 1 to 70% by weight.

In the solderable alloy of the present invention, other element may be contained in addition to the components described above, if desired. Such element can be exemplified by indium, silver, copper, nickel, zinc, cobalt, iron, manganese, molybdenum, tungsten, gold, cadmium, antimony, arsenic, bismuth, titanium, thallium, platinum, phosphorus, boron, tellurium, sulfur, iridium, gallium, germanium, chromium, strontium, tantalum, niobium, vanadium, barium, lithium, ruthenium and rubidium. Two or more kinds of these may be contained in combination. In particular, incorporation of phosphor in an amount of from 0.1 to 20% by weight, and preferably from 1 to 10% by weight, or boron in an amount of from 0.01 to 10% by weight, and preferably from 0.1 to 5% by weight, makes the solderability hardly deteriorate on account of heat. Incorporation of indium in an amount of from 0.1 to 20% by weight, and preferably from 1 to 10% by weight, can lower the melting point of the alloy. Incorporation of silver in an amount of from 0.1 to 20% by weight, and preferably from 1 to 10% by weight, can decrease what is called solder loss, a phenomenon in which the alloy dissolves into a solder bath when the solderable alloy is immersed in the solder bath.

The solderable alloy of the present invention can be formed by conventional methods. For example, it can be formed into a thin film by a wet process such as electrolytic plating or electroless plating, or a dry process such as vacuum deposition, sputtering or ion plating. Taking account of formation cost, the wet process is more preferred than the dry process such as sputtering.

In the case of the dry process, an alloy thin film comprised of palladium and lead and/or tin may be directly formed. Alternatively, a palladium thin film and a lead thin film and/or a tin thin film may be formed in layers in any desired order, followed by annealing to cause the respective elements to diffuse one another. In particular, the alloy may preferable be produced by forming a palladium thin film and a lead thin film and/or a tin thin film in layers in this order, followed by annealing to cause the respective elements to diffuse one another.

In the case when, of the wet process, electrolytic plating is carried out to form the solderable alloy of the present invention, a solderable alloy plating solution containing from 0.001 to 2 mol/lit., and preferably from 0.01 to 0.5 mol/lit., of a palladium compound, and from 0.001 to 2 mol/lit., and preferably from 0.01 to 0.5 mol/lit., of a lead compound and/or from 0.001 to 3 mol/lit., and preferably from 0.01 to 1 mol/lit., of a tin compound may usually be used and plating may be carried out under conditions of a current density of from 0.1 to 10 A/dm², and preferably from 1 to 5 A/dm², a pH of from 1 to 13, and preferably from 2 to 9, and a temperature of from 10 to 90°C, and preferably from 15 to 50°C. A complexing agent, a pH adjuster, etc., conventionally used, may also be optionally added to such an electrolytic plating solution.

In the case when a thin film comprising the solderable alloy of the present invention is formed on an isolated circuit which is present in a printed circuit board and to which no electrical connection can be taken or in the case when a thin film comprising the solderable alloy of the present invention is formed on a printed circuit board having so small-diameter through-holes or so narrow circuit pattern width that, when electrolytic plating is applied, some inside surfaces of the through-holes can not be plated or bridges may be formed between circuits, they may preferably be formed by, of the wet process, electroless plating. In this case, a solderable alloy electroless plating solution containing from 0.001 to 2 mol/lit., and preferably from 0.01 to 0.5 mol/lit., of a palladium compound, from 0.001 to 2 mol/lit., and preferably from 0.01 to 0.5 mol/lit., of a lead compound and/or from 0.001 to 3 mol/lit., and preferably from 0.01 to 1 mol/lit., of a tin compound, and 0.01 to 1 mol/lit., and preferably from 0.1 to 0.5 mol/lit., of a reducing agent may usually be used and plating may be carried out under conditions of a pH of from 1 to 13, and preferably from 3 to 10, and a temperature of from 30 to 95°C, and preferably from 40 to 93°C. Various additives as exemplified by a complexing agent such as citric acid or malic acid, or an alkali metal salt thereof, and a pH adjuster such as ammonium or ammonium chloride may also be optionally added to such an electroless plating solution.

In the case of such an electroless plating solution to form the solderable alloy, the palladium ions produced by ionization of the palladium compound contained in that solution accelerate the reduction reaction, so that the deposition rate of the solderable alloy can be greatly improved. Hence, it becomes possible to control the deposition rate over the range of as wide as from 1 to 20 µm/hr, by adjusting temperatures, metal salt densities, etc.

As the palladium compound usable in the wet process described above, any compounds conventionally used in wet processes can be used. For example, it is possible to use palladium chloride, palladium sulfamate, palladium methanesulfonate, etc.

As the lead compound and the tin compound, any compounds conventionally used in wet processes can also be used. For example, it is possible to use lead compounds as exemplified by lead chloride, lead sulfamate and lead borofluoride, and tin compounds as exemplified by stannous chloride, tin sulfamate and tin borofluoride.

As the reducing agent, any known agents conventionally used in electroless plating can be used. For example, it is possible to use hydrazine, formalin, sodium hypophosphite, dimethylamineborane [(CH₃)₂NHBH₃] and sodium borohydride.

In the case when sodium hypophosphite is used as the reducing agent, phosphorus elements are deposited together in the alloy. In the case when a boron type reducing agent such as sodium hypophosphite or dimethylamineborane [(CH₃)₂NHBH₃] is used, boron elements are deposited together. In these cases, the solderable alloy can be made to have a solderability improved in resistance to heat.

In the case when the solderable alloy of the present invention is formed by electrolytic or electroless plating on the surfaces of the portions such as copper through-holes to be soldered, it is preferable to previously apply a usual subbing treatment to the surfaces of the portions to be soldered.

As described above, the solderable alloy of the present invention contains palladium in an amount of from 0.01 to 90% by weight, and hence can have a superior solderability, may hardly cause deterioration of its solderability on account of heat or humidity and also requires no flux treatment when soldered. It therefore becomes unnecessary to use fluorine type solvents or chlorine type solvents to remove the flux by cleaning.

In the case when the solderable alloy is formed by electroless plating, the palladium ions present in the plating bath accelerates the reduction reaction to make it possible to control the deposition rate over a wide range.

### EXAMPLES

The present invention will be described below in greater detail by giving Examples.

### Example 1

To an aqueous solution containing palladium chloride (0.1 g/lit.), stannous chloride (50 g/lit.), lead sulfamate (10 g/lit.), sodium citrate (50 g/lit.) and sodium hypophosphite (50 g/lit.), sulfamic acid was added to adjust the pH of the solution to 4.5. Thus, an electroless plating solution was prepared.

The temperature of the electroless plating solution obtained was kept at 70°C, and an iron plate (length: 100 mm; width: 50 mm; thickness: 1 mm) whose surface had been cleaned by a conventional method was immersed in the solution with stirring to form on its surface a solderable alloy of 10 µm thick. The solderable alloy thus obtained was composed of 8% by weight of palladium, 20% by weight of lead, 63% by weight of tin and 3% by weight of phosphorus.

The solderability of this solderable alloy was evaluated by solder spreading tests carried out in the following way immediately after its formation (i.e., after exposure to the atmosphere for 2 days), after accelerated deterioration tests [i.e., after a heating test (i.e., after heating at 100°C for 16 hours in the atmosphere), after a humidity cabinet test (i.e., after left for 2 weeks in an environment of 40°C and 90-95%RH) and after an atmospheric corrosion test (i.e., after left for 1 month in the atmosphere)].

### Solder spreading test:

On the solderable alloy formed on the iron plate, 10 pieces of solder pellets (area: 10 mm²; thickness: 1 mm) were laid separately one another, and the whole was heated for 5 minutes in a thermostatic chamber kept at 250°C to cause the solder pellets to melt. Then, the areas of the solder spread on the solderable alloy were each measured using a planimeter. An average value of the measurements was regarded as a solder spread area. In this case, the larger the solder spread area is, the better the solderability is. In this test, no flux was used. Results obtained are shown in Table 1.

**Table 1**

| Solder spread area (mm²) | | | | |
|---|---|---|---|---|
| | Immediately after formation | After accelerated deterioration test | | |
| | | After heating test | After humidity cabinet test | After atmospheric corrosion test |
| Example: | | | | |
| 1 | 13.6 | 13.1 | 12.8 | 13.0 |

| Comparative Example: | | | | |
|---|---|---|---|---|
| 1 | 14.7 | 9.2 | 9.1 | 8.9 |
| 2 | 8.2 | 7.0 | 7.0 | 7.0 |

As is clear from Table 1, the solderable alloy of the present Example exhibited a good solderability immediately after its formation, and also showed little changes even after the accelerated deterioration test.

### Comparative Example 1

Using a SLOTOLET bath (20°C, pH 2.0; available from Reihorudo , Inc.) hitherto widely used to produce solderable alloys, a 10 µm thick solderable alloy was formed by electrolytic plating (1.5 A/dm²) on the same iron plate as used in Example 1. The resulting alloy was composed of 39% by weight of lead and 61% by weight of tin.

The solderability of the alloy thus obtained was evaluated in the same manner as in Example 1. Results obtained are shown in Table 1. As is clear from Table 1, the solderable alloy exhibited a good solderability immediately after its formation, but showed a great lowering of solderability after the accelerated deterioration test.

### Comparative Example 2

To an aqueous solution containing nickel sulfate (10 g/lit.), sodium citrate (30 g/lit.) and sodium hypophosphite, sulfuric acid was added to adjust the pH of the solution to 4.6. Thus, an electroless plating solution was prepared. While stirring this plating solution, the same iron plate as used in Example 1 was immersed therein to form phosphorus-containing nickel (91% by weight of nickel, 9% by weight of phosphorus) of 10 µm thick on the iron plate.

The solderability of the phosphorus-containing nickel thus obtained was evaluated in the same manner as in Example 1. Results obtained are shown in Table 1. As is clear from Table 1, it exhibited an unsatisfactory solderability even immediately after its formation, and showed a further lowering of solderability after the accelerated deterioration test.

### Example 2

To an aqueous solution containing palladium chloride (0.5 g/lit.), lead chloride (40 g/lit.), stannous chloride (20 g/lit.), sodium citrate (30 g/lit.) and sodium hypophosphite (60 g/lit.), citric acid was added to adjust the pH of the solution to 4.5. Thus, an electroless plating solution was prepared.

In the meantime, a 5 mm thick printed circuit board having copper through-holes (0.3 mm diameter) and copper through-hole lands which holes might clog if solder plating was applied by the solder leveler process was made ready for use. After a subbing treatment was applied thereto, the whole was immersed in the electroless plating solution previously prepared, for 20 to 30 minutes to form a solderable alloy with a uniform thickness on the surfaces of the insides of through-holes and the through-hole lands. The resulting alloy was composed of 2% by weight of palladium, 33% by weight of lead, 62% by weight of tin and 3% by weight of phosphorus. The alloy thus obtained exhibited a superior solderability as in Example 1.

Into the through-holes of the printed circuit board with the solderable alloy formed on the surfaces of the insides of through-holes, the wire leads of electronic parts having wire leads of 0.13 mm diameter were inserted from the top surface of the board. The resulting board was floated on a solder bath of 260°C for 5 seconds in the manner that its back surface came in contact with the solder bath. As a result, the insides of through-holes were closely and perfectly filled with the solder, and it was possible to electrically connect the electronic parts to the printed circuit board at a high joint strength.

Other electronic parts to the leads of which solder plating had been applied were also laid on the through-hole lands, and the whole was heated in a solder reflowing oven. As a result, there was no misregistration, and it was possible to electrically surface-mount the electronic parts to the through-hole lands at a high joint strength.

### Example 3

To an aqueous solution containing palladium chloride (0.5 g/lit.), lead methanesulfonate (30 g/lit.), tin methanesulfonate (30 g/lit.), sodium maleate (30 g/lit.) and sodium hypophosphite (50 g/lit.), methanesulfonic acid was added to adjust the pH of the solution to 4.0. Thus, an electroless plating solution was prepared.

In this plating solution, the same printed circuit board as used in Example 2 was immersed for 30 minutes at 80°C to form a solderable alloy of about 3 µm thick on the surfaces of the insides of through-holes and so on. The resulting alloy was composed of 2% by weight of palladium, 36% by weight of lead, 59% by weight of tin and 3% by weight of phosphorus. The alloy thus obtained exhibited a superior solderability as in Example 1. It was also possible to electrically connect the electronic parts at a high joint strength as in Example 2.

### Example 4

To an aqueous solution containing palladium chloride (0.1 g/lit.), lead sulfamate (20 g/lit.), tin methanesulfonate (30 g/lit.), sodium citrate (30 g/lit.) and sodium hypophosphite (30 g/lit.), sulfamic acid was added to adjust the pH of the solution to 3.0. Thus, an electroless plating solution was prepared.

In this plating solution, the same printed circuit board as used in Example 2 was immersed for 30 minutes at 90°C to form a solderable alloy of about 3 µm thick on the surfaces of the insides of through-holes and so on. The resulting alloy was composed of 1% by weight of palladium, 29% by weight of lead, 67% by weight of tin and 3% by weight of phosphorus. The alloy thus obtained exhibited a superior solderability as in Example 1. It was also possible to electrically connect the electronic parts at a high joint strength as in Example 2.

### Example 5

To an aqueous solution containing palladium chloride (0.1 g/lit.), lead chloride (20 g/lit.), stannous chloride (10 g/lit.), ammonium chloride (20 g/lit.), citric acid (30 g/lit.) and dimethylamineborane (3 g/lit.), ammonia water was added to adjust the pH of the solution to 9.0. Thus, an electroless plating solution was prepared.

In this plating solution, the same printed circuit board as used in Example 2 was immersed for 30 minutes at 60°C to form a solderable alloy of about 3 µm thick on the surfaces of the insides of through-holes and so on. The resulting alloy was composed of 0.3% by weight of palladium, 32% by weight of lead, 67.5% by weight of tin and 0.2% by weight of boron. The alloy thus obtained exhibited a superior solderability as in Example 1. It was also possible to electrically connect the electronic parts at a high joint strength as in Example 2.

### Example 6

To an aqueous solution containing palladium chloride (0.1 g/lit.), lead borofluoride (20 g/lit.), borofluoric acid (50 g/lit.), citric acid (20 g/lit.) and dimethylamineborane (3 g/lit.), ammonia water was added to adjust the pH of the solution to 4.2. Thus, an electroless plating solution was prepared.

In this plating solution, the same printed circuit board as used in Example 2 was immersed for 30 minutes at 60°C to form a solderable alloy of about 3 µm thick on the surfaces of the insides of through-holes and so on. The resulting alloy was composed of 1.2% by weight of palladium, 87% by weight of lead and 0.3% by weight of boron. The alloy thus obtained exhibited a superior solderability as in Example 1. It was also possible to electrically connect the electronic parts at a high joint strength as in Example 2.

### Example 7

To an aqueous solution containing palladium chloride (0.5 g/lit.), tin methanesulfonate (30 g/lit.), methanesulfonic acid (50 g/lit.) and dimethylamineborane (5 g/lit.), ammonia water was added to adjust the pH of the solution to 4.5. Thus, an electroless plating solution was prepared.

In this plating solution, the same printed circuit board as used in Example 2 was immersed for 30 minutes at 60°C to form a solderable alloy of about 3 µm thick on the surfaces of the insides of through-holes and so on. The resulting alloy was composed of 1.0% by weight of palladium, 98.5% by weight of tin and 0.5% by weight of boron. The alloy thus obtained exhibited a superior solderability as in Example 1. It was also possible to electrically connect the electronic parts at a high joint strength as in Example 2.

### Example 8

To an aqueous solution containing palladium chloride (0.1 g/lit.), lead borofluoride (20 g/lit.), tin borofluoride (10 g/lit.), silver borofluoride (3 g/lit.), borofluoric acid (100 g/lit.) and sodium hypophosphite (10 g/lit.), sodium hydroxide was added to adjust the pH of the solution to 4.0. Thus, an electroless plating solution was prepared.

In this plating solution, the same printed circuit board as used in Example 2 was immersed for 30 minutes at 90°C to form a solderable alloy of about 3 µm thick on the surfaces of the insides of through-holes and so on. The resulting alloy was composed of 4% by weight of palladium, 38% by weight of lead, 48% by weight of tin, 7% by weight of silver and 3% by weight of phosphorus. The alloy thus obtained exhibited a superior solderability as in Example 1. It was also possible to electrically connect the electronic parts at a high joint strength as in Example 2.

### Example 9

To an aqueous solution containing palladium chloride (1 g/lit.), lead borofluoride (5 g/lit.), tin borofluoride (10 g/lit.) and borofluoric acid (100 g/lit.), sodium hydroxide was added to adjust the pH of the solution to 4.5. Thus, an electrolytic plating solution was prepared. Using this plating solution, a solderable alloy of about 3 µm thick was formed by electrolytic plating (20°C, 10 minutes, 1 A/dm²) on the same printed circuit board as used in Example 2. The resulting alloy was composed of 3% by weight of palladium, 32% by weight of lead and 65% by weight of tin. The alloy thus obtained exhibited a superior solderability as in Example 1. It was also possible to electrically connect the electronic parts at a high joint strength as in Example 2. Even after a like printed circuit board on which the thin film of the solderable alloy had been formed was heated in the atmosphere at 150°C for 20 hours, it was possible to electrically connect the electronic parts at a high joint strength as in Example 2.

### Example 10

To an aqueous solution containing palladium chloride (1 g/lit.), lead sulfamate (10 g/lit.), stannous chloride (10 g/lit.), indium sulfamate (10 g/lit.) and sulfamic acid (50 g/lit.), sodium hydroxide was added to adjust the pH of the solution to 4.0. Thus, an electrolytic plating solution was prepared. Using this plating solution, a solderable alloy of about 3 µm thick was formed by electrolytic plating (40°C, 10 minutes, 1 A/dm²) on the same printed circuit board as used in Example 2. The resulting alloy was composed of 2% by weight of palladium, 32% by weight of lead, 29% by weight of tin and 37% by weight of indium. The alloy thus obtained exhibited a superior solderability as in Example 1. It was also possible to electrically connect the electronic parts at a high joint strength as in Example 2.

### Example 11

On a glass substrate, 1 µm thick palladium, 1 µm thick lead and 1 µm thick tin were successively formed in layers by sputtering. This was subjected to annealing at 200°C for 30 minutes in an atmosphere of a mixed gas of nitrogen gas and hydrogen gas to cause the respective elements to diffuse one another. Thus, a solderable alloy of about 3 µm thick was formed. Thereafter, this alloy was subjected to patterning by photolithography. On the remaining alloy, electronic parts were surface-mounted in the same manner as in Example 2. As a result, it was possible to electrically surface-mount the electronic parts at a high joint strength as in Example 2.

### INDUSTRIAL UTILITY

The solderable alloy of the present invention has a superior solderability, may hardly cause deterioration of its solderability on account of heat or humidity, requires no flux treatment when soldered, and therefore makes it unnecessary to use fluorine type solvents or chlorine type solvents used to remove the flux by cleaning. Hence, it is particularly useful as an alloy previously formed in a thin film on the portions to be soldered, of electronic parts and printed circuit boards when various types of electronic parts and printed circuit boards are joined at a high joint strength.

## Claims

1. A solderable alloy comprising lead and/or tin, wherein palladium is contained in an amount of from 0.01 to 90% by weight.

2. The solderable alloy according to claim 1, wherein the lead is contained in an amount of from 0.1 to 70% by weight, and the tin in an amount of from 0.1 to 90% by weight.

3. The solderable alloy according to claim 1 or 2, which further contains phosphorus in an amount of from 0.1 to 20% by weight.

4. The solderable alloy according to claim 1 or 2, which further contains boron in an amount of from 0.01 to 10% by weight.

5. The solderable alloy according to any one of claims 1 to 4, which further contains indium in an amount of from 0.1 to 20% by weight.

6. The solderable alloy according to any one of claims 1 to 5, which further contains silver in an amount of from 0.1 to 20% by weight.

7. A solderable alloy plating solution comprising from 0.001 to 2 mol/lit. of a palladium compound, and from 0.001 to 3 mol/lit. of a tin compound and/or from 0.001 to 2 mol/lit. of a lead compound.

8. The solderable alloy plating solution according to claim 7, which further contains from 0.01 to 1 mol/lit. of a reducing agent.

9. A method of producing the solderable alloy as described in claim 1, comprising carrying out electrolytic plating using the solderable alloy plating solution as described in claim 7, under conditions of a current density of from 0.1 to 10 A/dm², a pH of from 1 to 13 and a temperature of from 10 to 90°C.

10. A method of producing the solderable alloy as described in claim 1, comprising carrying out electroless plating using the solderable alloy plating solution as described in claim 8, under conditions of a pH of from 1 to 13 and a temperature of from 30 to 95°C.

11. A method of producing the solderable alloy as described in claim 1, comprising forming palladium and lead and/or tin in layers in any desired order by a dry plating process, followed by annealing to cause the respective elements to diffuse one another.
